Europäisches Patentamt

European Patent Office

Office européen des brevets

(11) Veröffentlichungsnummer: **0 346 975**
**A2**

## (12) EUROPÄISCHE PATENTANMELDUNG

(21) Anmeldenummer: 89201474.7

(22) Anmeldetag: 08.06.89

(51) Int. Cl.⁴: **G01N 24/04**

(30) Priorität: 14.06.88 DE 3820168

(43) Veröffentlichungstag der Anmeldung:
20.12.89 Patentblatt 89/51

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**
**Groenewoudseweg 1**
**NL-5621 BA Eindhoven(NL)**
(84) **FR GB NL**

(72) Erfinder: **Wichern, Andreas**
**Ehestorfer Weg 94a**
**D-2190 Hamburg 90(DE)**
Erfinder: **Leussler, Christoph Günter**
**Meldorfer Strasse 7**
**D-2000 Hamburg 20(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Kernspinuntersuchungsgerät mit einer Schaltung zum Entkoppeln der beiden Spulensysteme einer Quadraturspulenanordnung.**

(57) Kernspinuntersuchungsgerät mit einer Schaltung zum Entkoppeln der beiden Spulensysteme einer Quadraturspulenanordnung.

Die Erfindung betrifft ein Kernspinuntersuchungsgerät mit einer aus zwei Spulensystemen bestehenden Quadraturspulenanordnung und einer Schaltung zum Entkoppeln der beiden Spulensysteme. Bei einem solchen Kernspinuntersuchungsgerät läßt sich die Entkopplung zwischen den Spulensystemen dadurch verbessern, daß die Schaltung einen einstellbaren Kondensator enthält, der das eine Spulensystem mit dem anderen verbindet.

Kernspinuntersuchungsgerät mit einer Schaltung zum Entkoppeln der beiden Spulensysteme einer Quadraturspulenanordnung

Die Erfindung betrifft ein Kernspinuntersuchungsgerät mit einer aus zwei Spulensystemen bestehenden Quadraturspulenanordnung und einer Schaltung zum Entkoppeln der beiden Spulensysteme.

Ein solches Kernspinuntersuchungsgerät ist aus der Veröffentlichung von T.R. Fox anläßlich der SMRM 1987 bekannt. Dabei werden die beiden Spulensysteme über einen kapazitiven Spannungsteiler miteinander gekoppelt. Für das Funktionieren der Entkopplungsschaltung ist Voraussetzung, daß der Kopplungsfaktor kleiner ist als 0,1 %. Darüber hinaus arbeitet die Schaltung nur bei Frequenzen unterhalb von 10 MHz und besitzt nur eine begrenzte Entkopplungswirkung.

Aufgabe der vorliegenden Erfindung ist es, ein Kernspinuntersuchungsgerät der eingangs genannten Art so auszubilden, daß mit geringem Aufwand eine wirksame Entkopplung zwischen den Spulensystemen einer Quadraturspulenanordnung erreicht wird. Diese Aufgabe wird erfindungsgemäß dadurch gelöst, daß die Schaltung einen einstellbaren Kondensator enthält, der das eine Spulensystem mit dem anderen verbindet. Der Kondensator ruft einen Hochfrequenzstrom hervor, der dem durch die Kopplung bedingten Hochfrequenzstrom entgegengerichtet ist. Durch Variation der Kapazität dieses Kondensators kann dieser Strom so eingestellt werden, daß sich eine optimale Entkopplung ergibt.

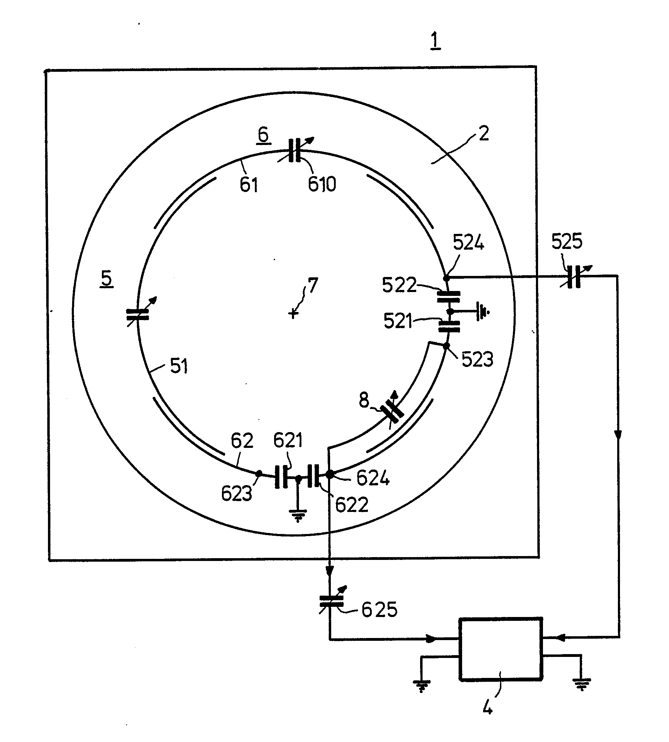

Die Erfindung wird nachstehend anhand der Zeichnung näher erläutert. Die Zeichnung zeigt in blockschematischer

Darstellung die für die Erfindung wesentlichen Komponenten eines Kernspinuntersuchungsgerätes 1. Das Kernspinuntersuchungsgerät erzeugt in seinem Untersuchungsbereich 2 ein senkrecht zur Zeichenebene verlaufendes, homogenes stationäres Magnetfeld mit einer magnetischen Flußdichte von z.B. 0,5 Tesla. Dadurch ergibt sich in dem Untersuchungbereich eine Larmorfrequenz für Wasserstoffprotonen von ca. 21,3 MHz. Durch ein zu dem stationären Magnetfeld senkrecht verlaufendes hochfrequentes Magnetfeld mit eben dieser Larmorfrequenz können die Kernspins der Wasserstoffprotonen in dem Untersuchungsbereich angeregt werden. Die dadurch im Untersuchungsbereich erzeugten Kernresonanzsignale induzieren in einer Quadraturspulenanordnung zwei Signale, die einem Empfänger 4 zugeführt werden. Die für die weitere Verarbeitung dieser Signale erforderlichen Komponenten des Kernspinuntersuchungsgerätes sind in der Zeichnung der Übersichtlichkeit halber nicht näher dargestellt.

Die Quadraturspulenanordnung umfaßt zwei um 90° gegeneinander versetzte Quadraturspulensysteme 5 und 6. Jedes Quadraturspulensystem besteht aus zwei um 180° gegeneinander versetzten Spulen 51 und 52 bzw. 61 und 62. Jede Spule umfaßt zwei in Richtung senkrecht zur Zeichenebene versetzte Leiterabschnitte, die um die Zentralachse 7 des Kernspinuntersuchungsgerätes einen Bogen von ca. 120° beschreiben und die durch zwei gerade, zur Zeichenebene senkrecht verlaufende Leiterabschnitte zu einer Schleife ergänzt werden.

Alle Spulen der Quadraturspulenanordnung sind auf die gleiche Resonanzfrequenz abgestimmt. Nur jeweils eine der Spulen eines Spulensystems - in diesem Fall die Spulen 62 und 52 - sind an den Empfänger 4 anschließbar; das andere Spulensystem ist damit lediglich induktiv gekoppelt.

Die nicht an den Empfänger 4 angeschlossenen Spulen 51 und 61 werden durch einen Kondensator 510 bzw. 610 in der Mitte des bogenförmigen Leiterabschnitts - bzw. in der Mitte beider bogenförmiger Leiterabschnitte - abgestimmt. Bei den an den Empfänger anschließbaren Spulen 52 und 62 sind in der Mitte zwei in Serie geschaltete Kondensatoren 521, 522 bzw. 621, 622 vorgesehen, deren gemeinsamer Verbindungspunkt jeweils an Masse angeschlossen ist. Einer der beiden Verbindungspunkte 523, 524 bzw. 623, 624 der in Serie geschalteten Kondensatoren mit den bogenförmigen Leiterabschnitten - in diesem Fall die Anschlüsse 523 und 624 - sind über abstimmbare Kondensatoren 525 bzw. 625 und nicht näher dargestellte Umschalter an die Eingänge des Empfängers 4 anschließbar. Die Summe der Kapazitäten der miteinander verbundenen Kondensatoren 522 und 525 bzw. 622 und 625 entspricht etwa der Kapazität des zweiten Kondensators 521 (bzw. 621), so daß sich auch eine zur Mittelebene der Spulen 52 und 62 symmetrische Feldverteilung ergibt.

Weil jede einzelne Spule einen 120°-Bogen eines Zylindermantels einnimmt, ergeben sich relativ große Überlappungsbereiche (30° zwischen den einzelnen Spulen), die an sich eine Kopplung zwischen den Spulen bewirken. Jedoch sind die durch die beiden Überlappungsbereiche einer jeden Spule mit den beiden Spulen des jeweils anderen Spulensystems hervorgerufenen Verkettungen des Magnetflusses einander entgegengerichtet, so daß die Spulen im Idealfall voneinander entkoppelt sind. In der Praxis ergeben sich jedoch infolge kleiner Unsymmetrien in der Spulengeometrie, insbesondere aber durch eine unsymmetrische Feldverteilung auf den Spulen, die durch eine nicht exakte Abstimmung hervorgerufen wird, Koppeleffekte zwischen den benachbarten Spulensystemen. Auch wenn der Koppelfaktor dabei nur Bruchteile eines Prozents beträgt, hat dies zur Folge, daß die mit einer Quadraturspulenanordnung gegenüber einem einzigen Spulensystem erreichbare Verbesserung des Signal-Rauschverhältnisses von maximal 3 dB fast vollständig verloren geht. Es ist daher wichtig, die beiden Spulen so gut wie möglich voneinander zu entkoppeln.

Diesem Zweck dient ein Kondensator 8, der zwischen die Anschlußpunkte 523 und 624 der Spulen 52 und 62 geschaltet ist. Dieser Kondensator ruft einen Strom hervor, der dem durch die Kopplung zwischen den Spulen bedingten Hochfrequenzstrom entgegengerichtet ist und diesen daher - zumindest weitestgehend - kompensiert. Die für die bestmögliche Entkopplung erforderliche Größe der Kapazität dieses einstellbaren Kondensators kann ermittelt werden, indem eine der Spulen 52 oder 62 an einen Hochfrequenzgenerator angeschlossen und die in der anderen Spule dabei induzierte Spannung gemessen wird und der Kondensator solange verstellt wird, bis die gemessene Spannung ein Minimum erreicht.

Die Messung der induzierten Spannung kann entweder direkt erfolgen oder dadurch, daß auf der Symmetrieachse eine kleine Pick-up-Spule (d.h. eine nicht resonante Aufnehmerspule) mit senkrecht zu den Spulen 51,52 angeordnetem Rahmen (wenn die Spule 52 an den Hochfrequenzgenerator angeschlossen ist) angeordnet und die hier induzierte Spannung gemessen wird. Die gleiche Wirkung ergibt sich, wenn der Kondensator 8 anstatt zwischen die Anschlüsse 523 und 624 an die Anschlüsse 524 und 623 angeschlossen wird.

Die Richtung des Stromes der durch die Verkopplung der Spulen in einer Spule hervorgerufen wird, hängt von der Unsymmetrie in der Spulengeometrie und in der Feldverteilung auf den Spulen ab. Es kann daher vorkommen, daß der durch die Kopplung bewirkte Strom nicht mit dem angenommenen Umlaufsinn fließt; in diesem Fall würde die angegebene Einschaltung des Kondensators 8 die Verkopplung zwischen den beiden Spulensystemen noch verstärken. Daher muß in solchen Fällen der Kondensator 8 entweder zwischen die Anschlüsse 523 und 623 oder 524 und 624 geschaltet werden.

Bei einem in der Praxis erprobten, bei 21,3 MHz betriebenen Spulensystem der aus der Zeichnung ersichtlichen Art konnte mit einem Kondensator, der in jedem Fall kleiner war als 15 pF, die Kopplung - ohne Kompensation betrug der Kopplungsfaktor 90024 - um mehr als 30 dB verringert werden (d.h. die bei Speisung z.B. der Spulen 52 in der Mitte der Quadraturspulenanordnung mit einer Pick-up-Spule in der zuvor erläuterten Weise gemessene Spannung konnte um mehr als 30 dB verringert werden gegenüber dem Zustand ohne den Kondensator 8).

Vorstehend wurde die Erfindung in Verbindung mit einer Quadraturspulenanordnung beschrieben, bei der von den beiden Spulen eines Spulensystems nur jeweils eine an den Hochfrequenzsender bzw. Hochfrequenzempfänger anschließbar ist, jedoch ist die Erfindung auch bei Quadraturspulenanordnungen anwendbar, bei denen jede der beiden Spulen eines Spulensystems an den Sender bzw. Empfänger angeschlossen ist - vergl. EP-OS 71 896. Schließlich ist die Erfindung auch bei solchen Quadraturspulenanordnungen anwendbar, bei denen jedes Spulensystem nur aus einer einzigen Hochfrequenzspule besteht. Grundsätzlich ist die Schaltung bei allen Quadraturtspulenanordnungen anwendbar, bei denen die Speiseleitung ebenfalls über zwei in Serie geschaltete Kapazitäten anschließbar ist.

## Ansprüche

1. Kernspinuntersuchungsgerät mit einer aus zwei Spulensystemen bestehenden Quadraturspulenanordnung und einer Schaltung zum Entkoppeln der beiden Spulensysteme, dadurch gekennzeichnet, daß die Schaltung einen einstellbaren Kondensator (8) enthält, der das eine Spulensystem (5,6) mit dem anderen verbindet.

2. Kernspinuntersuchungsgerät nach Anspruch 1, dadurch gekennzeichnet, daß jedes Spulensystem (5,6) aus zwei auf dem Umfang eines Zylinders um 180° versetzten Spulen (51,52; 61,62) besteht, die beide auf die gleiche Resonanzfrequenz abgestimmt sind, daß eine der beiden Spulen (52; 62) an einen Hochfrequenzsender bzw. -empfänger (4) anschließbar ist, und daß einer der beiden Anschlußpunkte (523, 524) der anschließbaren Spule (52) des einen Spulensystems (5) mit einem Anschlußpunkt (623, 624) der anschließbaren Spule (62) des anderen Spulensystems (6) verbunden ist.